# EUROPEAN PATENT SPECIFICATION

(11) **EP 0 554 350 B1**
(45) Date of publication and mention of the grant of the patent: **02.04.1997**
(21) Application number: 91919776.4
(22) Date of filing: 24.10.1991
(51) Int. Cl.: H01J 61/18, H01J 61/22, H01J 61/12

(54) **HIGH POWER LAMP**
HOCHLEISTUNGSLAMPE
LAMPE A HAUTE PUISSANCE

(30) Priority: 25.10.1990 US 604487; 23.10.1991 US 779718
(43) Date of publication of application: 11.08.1993
(73) Proprietor: FUSION SYSTEMS CORPORATION, Rockville, MD 20855 (US)
(72) Inventor: DOLAN, James, T., Frederick, MD 21702 (US); URY, Michael, G., Bethesda, MD 20817 (US); WOOD, Charles, H., Rockville, MD 20850 (US); WAYMOUTH, John, F., Marblehead, MA 01945 (US)
(74) Representative: Schwepfinger, Karl-Heinz, Dipl.-Ing.
(86) International application number: US9107865
(87) International publication number: WO9208240

(56) References cited:
- US-A- 4 476 413
- US-A- 4 810 938
- US-A- 4 945 290
- APPLIED SPECTROSCOPY, vol.30, 1976, BALTIMORE US pages 507 - 509 CHILDS ET AL. 'Some characteristics of low pressure, sulfur, microwave-excited, electrodeless discharge lamps'
- ANALYTICAL CHEMISTRY, vol.49, 1977, COLUMBUS US pages 551 - 554 BENTLEY ET AL. 'Preparation of electrodeless discharge lamps for elements forming gaseous covalent hydrides'
- PATENT ABSTRACTS OF JAPAN vol. 4, no. 40 (E-004) 28 March 1980 & JP-A-55 010 755 (USHIO INC) 25 January 1980

## Description

The present invention is directed to a new, high power lamp.

High power lamps are used for many illumination applications. The incandescent and fluorescent lamps, so familiar in homes and offices, do not provide enough illumination for many commercial and industrial applications. In fact, the lamp which has gained acceptance and which is typically used for high power illumination is known as the high intensity discharge (HID) lamp. This lamp is simple in structure, and generally consists of a glass envelope which contains two electrodes and a fill which vaporizes and becomes a gas when the lamp is operated.

The fill in the HID lamp usually contains mercury as its primary component. However, this is undesirable because mercury is a highly toxic and environmentally hazardous substance. Thus, if a HID lamp should break, dangerous mercury fumes would be emitted, and after the useful life of the lamp is over, there is no easy way to safely dispose of the mercury containing envelope. The widespread use of mercury containing lamps has been recognized as a serious environmental problem.

It is a feature of the present invention that instead of mercury, a substance which contains sulfur or selenium is used in the lamp fill.

In accordance with a first aspect of the present invention, elemental sulfur or selenium, or compounds of these elements, is included in a lamp fill. The fill is present at a pressure of at least about 98 kPa (1 atmosphere), and is excited with electromagnetic energy at a relatively high power density. Each of the above-mentioned substances has a low vapor pressure at room temperature, yet a high vapor pressure at typical lamp operating temperatures. The preferred embodiment of the invention utilizes a sulfur fill.

In accordance with a further aspect of the invention, elemental sulfur or selenium, or compounds of these elements are used as the primary radiating component of a lamp fill. The term "primary radiating component" as used herein means that radiating component of the fill which emits the largest part of the radiant energy emitted from the lamp during operation of the lamp, or that radiating component which is the sole radiating component in the fill.

There are many ways to measure how good a lamp is, and amongst those skilled in the lamp art the use of various standardized performance indicators has arisen. These include the luminous efficacy of the lamp, its rated life, lumen maintenance, chromaticity, and color rendering index (CRI). Finally, the stability of the color of the light which is emitted by the lamp is important, as this may change over time. The closer these accepted indicators are to ideal, the better the performance of the lamp.

As described above, the lamp of the invention avoids the environmental hazards which are associated with mercury based lamps, and additionally the resultant performance indicators for the lamp are relatively good.

In a first embodiment of the invention, a high power lamp of the electrodeless type is provided, which is powered by microwave energy. High power electrodeless lamps are well known in the art, but have generally, if not always, contained a mercury fill. Additionally, the lamps have primarily been used for their output in the ultraviolet rather than the visible portion of the spectrum. In the electrodeless lamp of the invention, a high pressure fill at least as high as 98 kPa (1 atmosphere) is utilized, which includes sulfur or selenium, or a compound thereof. Additionally, the fill may include an inert gas such as argon or xenon. The high pressure fill is excited at power densities in excess of 50 watts/cc, and preferably in excess of 100 watts/cc. Furthermore, various additives such as metal halides, arsenic, boron, etc., may be included in the fill to emphasize different areas of the spectrum.

The efficiency of production of useful radiation of the lamp of the invention is relatively high. In fact, it is significantly higher than for the conventional electrodeless lamp which utilizes a mercury fill. The ability to provide such a lamp is an unexpected result, as the fill substances used in accordance with the invention are lighter than mercury and form stable molecules at the wall temperature, so that they would be expected to have a higher heat conductivity than that of mercury so that it would be expected that more heat would be lost to the bulb walls, and that the efficiency of production of useful radiation would be lower than with the mercury lamp.

In a further embodiment of the invention, an arc lamp which has electrodes is provided. This is similar to the previously described mercury containing HID lamp, but instead of mercury, the fill includes a sulfur or selenium containing substance. As in the case of the electrodeless lamp, the addition of substances to the fill may be used to emphasize particular spectral regions. For example, sodium might be used to increase the orange and red radiation from the lamp.

In the prior art, low pressure, low power lamps are known which have been used in the laboratory for the scientific study of the spectrum (atomic spectroscopy). It is conventional in such laboratory work to use each of the elements of the periodic table, including the fill substances proposed herein, as the fill for electrodeless and arc lamps, so as to generate the atomic and molecular spectra of such elements. However, such lamps would be wholly unsuitable as high power visible, illumination sources. In fact, when the spectra generated with the lamps of the present invention were compared with the atomic or molecular spectrum generated by the low power, low pressure atomic spectroscopy lamps using the same fill, it was noted that for at least some implementations of the present invention, the ultraviolet part of the spectrum which appeared prominently in the spectrum of the atomic spectroscopy source was substantially and unexpectedly suppressed in the lamp of the invention, thus resulting in higher luminous efficacy, and in the generation of less harmful ultraviolet radiation.

It is thus an advantage of the present invention that a new, high power lamp is provided which does not need to contain mercury.

It is a further advantage of the invention that a new, high power lamp bulb is provided which does not need to contain mercury.

It is a further advantage of the invention that a new high power lamp is provided which has relatively good performance indicators of the type discussed above and/or other performance indicators.

The invention will be better appreciated by referring to the accompanying drawings, wherein:

Figure 1 shows a first embodiment of the invention.

Figure 2 shows a further embodiment of the invention.

Figures 3 to 6 show arc electrode configurations.

Figure 7 is a spectral plot for an electrodeless lamp utilizing a sulfur bulb fill.

Figure 8 is a spectral plot for an electrodeless lamp utilizing a bulb fill containing sulfur and cadmium iodide.

Figure 9 is a spectral plot taken from a lamp utilizing a bulb fill containing selenium.

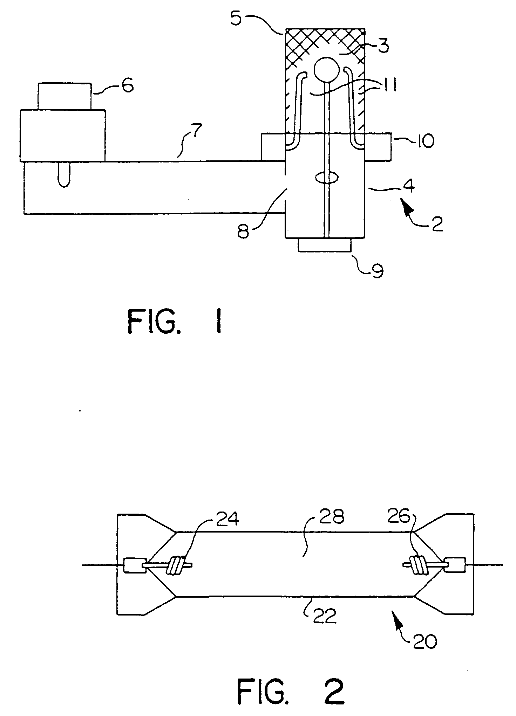

Referring to Figure 1, a first embodiment of the invention is depicted. Lamp 2 is an electrodeless lamp which is powered by microwave energy. Bulb 3, which contains a high pressure fill, and is made of quartz or other suitable material, is supported in a microwave cavity, which is comprised of conductive housing 4 and mesh 5. Magnetron 6 generates microwave energy, which is fed by waveguide 7, to coupling slot 8 of the microwave cavity.

This excites the bulb fill to a plasma state, whereupon light is emitted by the fill, which is transmitted out of the cavity through mesh 5. The mesh is metallic, and is constructed so that it is substantially opaque to microwave energy, while being substantially transparent to the light which is emitted by bulb 3. The bulb is rotated by rotator 9, and the bulb envelope is cooled by gas which is fed in to plenum 10 and out through nozzles 11.

In accordance with an aspect of the invention, the fill in bulb 4 includes elemental sulfur or selenium, or a compound of one of these elements. In accordance with a further aspect of the invention, this substance is present as the primary radiating component of the bulb fill. It is further desirable to use a fill component which aids in starting the discharge, and for example, a small amount of an inert gas, such as argon or xenon may be used for this purpose.

The lamp which is shown in Figure 1 may be characterized as a high power, high pressure lamp. Thus, the fill in bulb 3 is present in amounts such that the fill pressure is at least 98 kPa (one atmosphere) or above at operating temperature, and is preferably (196-1960 kPa (2 to 20 atmospheres). Additionally, the amplitude of the microwave energy which is fed to the cavity is such that the power density of the energy which is coupled to the fill is at least 50 watts/cc, and preferably greater than 100 watts/cc. The maximum power density which can be used is in part a function of bulb cooling, and with present technology, it is anticipated that power densities of at least a few hundred watts/cc may be used. It should be understood that in the term "power density", the volume (cc) refers to the volume of light emitting gas rather than to the volume of the bulb. It should be further understood that the absolute amount of the primary fill component in solid form which is used in the bulb may vary depending on which substance is used, e.g., sulfur or selenium, but the amount always will be such to produce the desired pressure range at operating temperature, i.e., the temperature of the bulb during normal operation at a power density of 50 watts/cc or greater. The fill pressure is mainly controlled by the primary fill component, which typically has a substantially higher partial pressure than that of the inert gas when the lamp is operational. Further, the illumination provided by the lamp shown in Figure 1 may be augmented in various regions of the spectrum by including certain additives in the fill. By way of non-limitative examples such additives may include metal halides, arsenic, boron, and bismuth. Examples of some of the many metal halides which can be used are CdI₂, HgCl, and InI₃. Also, in certain implementations, the addition of some mercury may improve operation by reducing the restrike time of the lamp.

As noted above, in addition to using sulfur and selenium in elemental form, compounds of these elements may be used. For example, InS, As₂S₃, SeO₂, and SeCl₄, as well as other compounds of sulfur and selenium, may be used. The term "a sulfur containing substance" as used herein, includes both elemental sulfur and sulfur compounds, while the same is true for the corresponding terms as applied to selenium. It should be appreciated that the primary radiating component of the fill may be comprised of a combination of a sulfur containing substance and a selenium containing substance, rather than only one of these substances. Additionally, the primary radiating component may be comprised of a mixture of the elemental form and a compound(s) of a particular substance or substances.

While microwave energy is the preferred mode of excitation of lamp 2, it would also be possible to provide excitation with electromagnetic energy in the radio frequency range. Since this typically would involve wrapping an excitation coil around the bulb, which would obscure some of the emitted light, the microwave mode of excitation is preferred. However, the term "electromagnetic energy", as used herein, refers to both microwave and r.f. modes. Also, while the microwave cavity which is illustrated in Figure 1 does not include a reflector, a reflecting cavity could also be used.

As mentioned above, it appears that the performance indicators of the lamp of the invention are relatively good. In this regard it is noted that electrodeless lamps, which have heretofore been used mainly to produce ultraviolet as opposed to visible light, tend to maintain their lumen output at a high level for a longer period of time than arc lamps, and this may be an advantageous property of the electrodeless lamp embodiment of the present invention.

An additional advantage of the present lamp is that the primary radiating fill component may be a single element. Thus, the most common type of HID lamp presently used for high power illumination applications is the metal halide type HID lamp, wherein mercury is combined with the halide of another metal or metals in order to achieve the desired spectral output. A commonly used combination is Hg + ScI₃ + NaI. The partial pressure of the additive metals is determined by the amount of metal halide in the lamp and by the temperature of the coldest spot on the lamp. The result is that variations in these parameters due to manufacturing tolerances or lamp aging will cause changes in the partial pressure of the additive, which in turn causes changes in the amount of output and in the spectral distribution of the output. On the other hand, since the present lamp may have only a single radiating fill component, or in accordance with an aspect of the invention have a fill which consists essentially of a sulfur containing substance or a selenium containing substance, and an inert gas, any effect caused by the partial pressures of different fill components changing at different rates will not occur.

A further advantage of the lamp of the invention is that it may emit principally molecular as opposed to atomic radiation which results in a smoother spectrum without peaks or abrupt transitions and possibly a better color rendering index. In this regard it is noted that non-metals have found little application as fill materials in the prior art, and one reason for this is that the primary atomic spectral lines of the non-metals do not lie in the visible region. However, the present invention, at least in certain implementations relies on molecular radiation as the dominant source, and is able to provide radiation principally within the visible range. A unique feature of the lamp of the present invention may be that it is a high luminous efficacy lamp which emits principally molecular radiation.

A still further advantage of the electrodeless lamp embodiment of the invention is that it is a compact, high power, visible radiator. Thus, the diameter of the bulb is typically only 2-3 cm, while outputs of about 140 lumens/watt or greater are possible.

A further embodiment of the invention is shown in Figure 2. This is an arc lamp 20 which is comprised of quartz envelope 22 having electrodes 24 and 26, and containing fill 28. To excite the fill, an A.C. voltage is impressed across the electrodes, whereupon an arc discharge occurs therebetween

In accordance with the invention, the fill in envelope 22 includes a sulfur containing substance or a selenium containing substance. In accordance with a further aspect of the invention, this fill substance is the primary radiating component in the fill. The substance may be elemental sulfur or selenium, or compounds of these elements. Additionally, a small amount of an additional gas to aid in starting is provided, which can be an inert gas, such as argon or xenon.

As in the case of the electrodeless lamp, the fill is present at a high pressure of at least about 98 kPa (1 atmosphere) and preferably in the range of about 196-1960 kPa (2-20 atmospheres). This pressure is controlled mainly by the sulfur or selenium containing substance, the partial pressure of which is at least about 1 atmosphere. Additionally, an electrical voltage is applied across the electrodes such that a power density of at least 60 watts/ cm exists. The electrodes 22 and 24 are made of or plated with a special material, to prevent chemical reactions with the fill gas which may lead to electrode deterioration.

In accordance with an aspect of the invention, the electrodes may be graphite rods. In view of the fact that the shanks of such electrodes will not participate in any electrode redeposition cycle which the tips of the electrodes may be part of, it is necessary to protect the electrode shanks at lower temperatures to prevent "tail erosion" which may occur due to reaction with the fill gas.

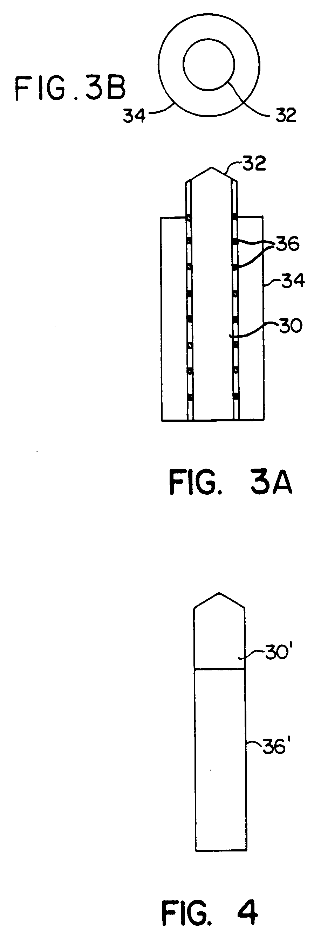

Figures 3 and 4 illustrate two designs for protecting the low temperature shank of a graphite electrode. In Figure 3, graphite electrode 30 has an alumina sleeve 34 around its shank. Since graphite is likely to react with alumina at elevated temperatures, a barrier layer 36 of platinum is interposed between the graphite rod and alumina sleeve. The electrode tip 32 extends beyond the sleeve in that the alumina can only extend to the point at which the operating temperature is about 1500 K.

In the embodiment of Figure 4, the platinum barrier 36' by itself is used to prevent reaction between graphite and the bulb fill. The height of the platinum barrier layer is determined experimentally to limit the maximum temperature to which the platinum is exposed.

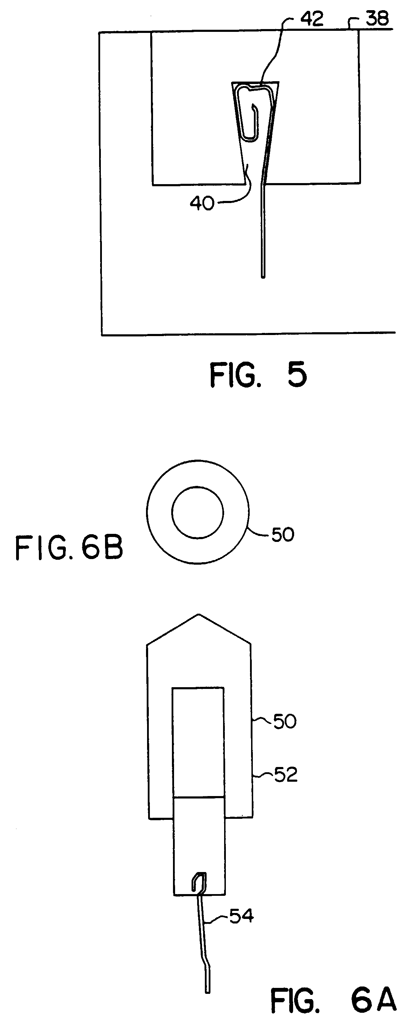

Figure 5 shows how the graphite rod may be attached to a molybdenum sealing foil. The foil 42 (about 0.03 mm (0.001") thick) is folded and slipped into a machined keyway 40 in the base 38 of the graphite rod. Since after sealing, the foil is under considerable tension due to the mismatch of expansion coefficient between quartz and moly, it is pulled tightly into the wedge-shaped keyway. It will probably be necessary to platinize the end of the moly foil, because fill gas can penetrate into the seal region as far as the end of the foil.

In accordance with a further aspect of the invention, "inert" electrodes which may be composed principally of refractory oxides may be used. These oxides will normally not be electrically conductive, and they must be made conductive by preparation in the form of a so-called "cermet", in which a blend of metallic particles and refractory oxide particles is pressed and sintered into a refractory body. Figure 6 shows a cermet electrode, wherein the cermet 50 is pressed around a platinized tungsten rod 52. The platinized tungsten support rod is fastened to the moly sealing ribbon 54 in the same manner as shown in Figure 5. The platinum coating of the exposed tungsten rod shank serves to protect the tungsten from attack by the fill vapor. The cermet electrodes may incorporate thoria and molybdenum or tungsten, and electrodes incorporating a yttria-ruthenium combination are also known. In electrodes such as are shown in Figure 6, the metal particles are shielded from reaction with the fill vapor by the refractory oxide, and the refractory oxide is more stable than the corresponding sulfide. Thus, reaction with, for example, sulfur vapor should be relatively small.

Alternatively, in accordance with the invention, electrodes of platinum, rhenium, or osmium may be used. Such electrodes may be fashioned of the metal in pure form, or the metal may be coated on a tungsten base.

The lamp electrodes may be coated with an electron emissive material, such as an alkalai earth sulfide (e.g. BaS). This reduces the effective electrode resistance, which leads to a reduction in the required ignition voltage and operating electrode losses. A tungsten electrode may be coated with alkalai earth sulfide material along its length from the sealed base to a point where the electrode becomes too hot during operation for stable tungsten/bulb fill material compounds to form.

In one implementation of the invention, the fill of either an electrodeless or arc lamp is arranged so that a sulfur or selenium containing substance is the sole radiating component in the bulb fill. In such an implementation, the sulfur or selenium containing substance may be the only substance in the fill except for a small amount of a gas to aid starting, e.g., argon or xenon.

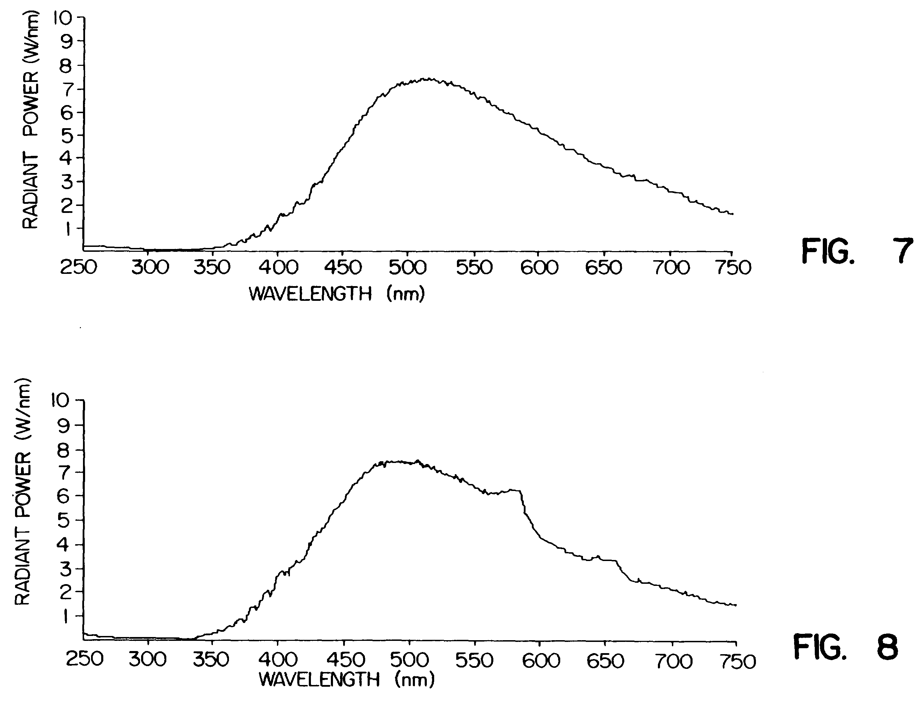

As a specific example of the invention, an electrodeless quartz bulb of spherical shape having an internal diameter of 2.84 cm was filled with .062 mg-moles/cc of sulfur, and 8 kPa (60 torr) of argon. When the bulb was placed in a microwave cavity and excited with microwave energy at a power density of about 280 watts/cc, visible light was emitted having a spectrum as shown in Figure 7. The luminous efficiency of the lamp was about 140 lumens/watt. Additionally, it is noted from the spectrum that there is minimal UV radiation beneath 350 nm. This feature helps to increase the luminous efficacy of the lamp and also enhances the safety of the lamp, as UV radiation is a health hazard. It is also noted from Figure 3 that the spectral plot is smooth and does not contain sharp peaks, which results from the fact that the lamp is principally a molecular as opposed to an atomic radiator.

As a further specific example of the invention, an electrodeless bulb of spherical shape having an internal diameter of 2.84 cm was filled with .053 mg-moles/cc of sulfur, .008 mg-moles/cc of cadmium and .003 mg-moles/cc of cadmium iodide. When the lamp was excited with microwave energy at a power density of 280 watts/cc, visible light was emitted having a spectrum as shown in Figure 8. The luminous efficacy of the lamp was about 134 lumens/watt. Additionally, it is noted that the spectrum has a shoulder at 580 nm, which is caused by the CdS and another shoulder at 650 nm, which is caused by the CdI.

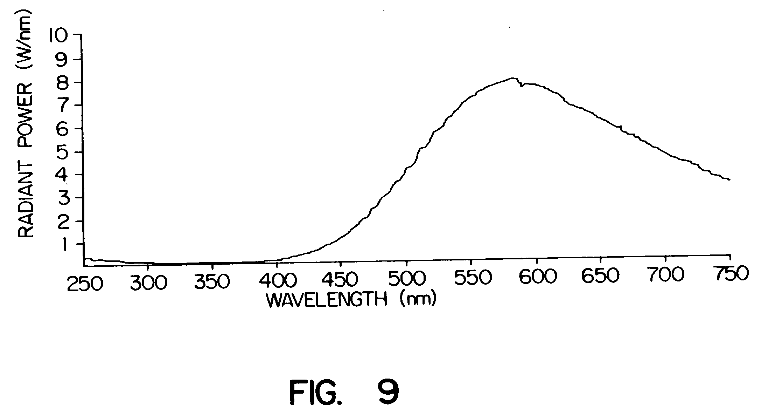

As a further specific example, an electrodeless quartz bulb having a volume of 12 cc was filled with 54 mg of selenium, resulting in 5.7 x 10⁻⁵ mol/cc, and with 8 kPa (60 torr) of argon. The bulb was placed in a microwave cavity and excited with 3500 watts of microwave energy. A spectrum which was measured from the output of the bulb is shown in Figure 9.

A new, high power lamp which can be made without mercury has thus been disclosed. While the lamp has been described primarily as a high power visible source of illumination, certain implementations may find use in other areas of the spectrum, e.g., the U.V. Additionally, while the invention has been illustrated in accordance with specific embodiments, it should be understood that variations falling within the invention will occur to those skilled in the art, and that the invention is to be limited only by the claims which are appended hereto.

## Claims

1. A lamp bulb for providing visible radiation when in operation, comprising,
a light transmissive envelope, and
a fill in said envelope including elemental sulfur in gaseous form which is obtainable when said fill is excited by sufficient power in operation in an amount such that the excited fill emits visible radiation from the elemental sulfur with substantially all of the radiation from the elemental sulfur being emitted in a continuous band at wavelengths longer than 350 nm.

2. The lamp bulb of claim 1 in combination with,
means for exciting said fill with sufficient power to obtain said elemental sulfur in gaseous form during operation which emits said visible radiation and said radiation substantially all of which is emitted in a continuous band at wavelengths longer than 350 nm.

3. The apparatus of claim 2 wherein said visible radiation from the bulb is primarily from said elemental sulfur.

4. The apparatus of claim 3 wherein said fill further includes a starting gas.

5. The apparatus of claim 3 wherein said visible radiation is molecular radiation from the sulfur.

6. The apparatus of claim 3 wherein the pressure of the excited fill is at least one atmosphere.

7. The apparatus of claim 6 wherein the partial pressure of the elemental sulfur in the excited fill is at least one atmosphere.

8. The apparatus of claim 6 or 7 wherein, said lamp bulb is electrodeless, and said means for exciting applies microwave or r.f. power to the fill.

9. The apparatus of claim 8 wherein the microwave or r.f. power which is applied to the fill is at a power density of at least 50 watts/cc.

10. The apparatus of claim 3 or 7 wherein said lamp bulb includes electrodes.

11. A lamp bulb for providing visible radiation, comprising,
a light transmissive envelope, and
a fill in the envelope which contains elemental selenium in gaseous form which is obtainable when said fill is excited by sufficient power in operation in an amount during excitation such that when the fill is excited with sufficient power, the excited fill emits visible radiation from the elemental selenium with substantially all of the radiation from the elemental selenium being emitted in a continuous band at wavelengths longer than 400 nm.

12. The lamp bulb of claim 11 in combination with:
means for exciting said fill with sufficient power to cause it to emit said visible radiation, substantially all of which is emitted at wavelengths longer than 400 nm.

13. The apparatus of claim 12 wherein said visible radiation from the bulb is primarily from said elemental selenium.

14. The apparatus of claim 12 wherein the visible radiation which is emitted from the elemental selenium is molecular radiation.

15. The apparatus of claim 13 wherein the pressure of the fill during operation is at least one atmosphere.

16. The apparatus of claim 15 wherein the partial pressure of the elemental selenium during operation is at least one atmosphere.

17. The apparatus of claim 15 or 16 wherein said lamp bulb is electrodeless and wherein said means for exciting applies microwave or r.f. power to the fill.

18. The apparatus of claim 17 wherein said microwave or r.f. power which is applied to the fill is at a power densitiy of at least 50 watts/cc.

19. The apparatus of claim 13 or 16 wherein said lamp bulb includes electrodes.

20. The apparatus of claim 13 wherein said fill further includes a starting gas.

21. The apparatus of claim 10 or 19 wherein the electrodes are graphite members.

22. The apparatus of claim 21 wherein the shanks of the graphite electrodes are covered with alumina.

23. The apparatus of claim 22 wherein there is a platinum layer between the graphite electrode and the alumina.

24. The apparatus of claim 21 wherein the shanks of the electrodes are covered with platinum.

25. The apparatus of claim 10 or 19 wherein the electrodes are made of cermet.

26. The apparatus of claim 10 or 19 wherein the electrodes are made of platinum, rhenium or osmium.

27. The apparatus of claim 10 or 19 wherein the electrodes are coated with an electron emissive substance.

28. The apparatus of claim 3 or 13 wherein the excited fill includes mercury.

29. The apparatus of claim 3 or 13 wherein the excited fill includes sodium.

30. The apparatus of claim 3 or 13 wherein the excited fill includes arsenic or bismuth.

## Patentansprüche

1. Lampenkolben zum Liefern sichtbarer Strahlung beim Betrieb, enthaltend
einen lichtdurchlässigen Mantel und
eine Füllung in dem Mantel, die elementaren, gasförmigen Schwefel enthält, der beim Anregen der Füllung beim Betrieb durch eine ausreichende Leistung in einer derartigen Menge gewonnen werden kann, daß die angeregte Füllung infolge des elementaren Schwefels sichtbare Strahlung emittiert, wobei im wesentlichen die gesamte Strahlung infolge des elementaren Schwefels in einem zusammenhängenden Band bei Wellenlängen oberhalb von 350 nm emittiert wird.

2. Lampenkolben nach Anspruch 1, in Zusammenwirken mit
einer Einrichtung zum Anregen der Füllung mit einer ausreichenden Leistung, um den elementaren, gasförmigen Schwefel während des Betriebs zu gewinnen, der die sichtbare Strahlung und die Strahlung, die fast vollständig in einem zusammenhängenden Band bei Wellenlängen oberhalb von 350 nm emittiert wird, aussendet.

3. Vorrichtung nach Anspruch 2, wobei die sichtbare Strahlung aus dem Kolben in erster Linie vom elementaren Schwefel herrührt.

4. Vorrichtung nach Anspruch 3, wobei die Füllung weiterhin ein Zündgas enthält.

5. Vorrichtung nach Anspruch 3, wobei die sichtbare Strahlung Molekularstrahlung des Schwefels ist.

6. Vorrichtung nach Anspruch 3, wobei der Druck der angeregten Füllung wenigstens eine Atmosphäre beträgt.

7. Vorrichtung nach Anspruch 6, wobei der Partialdruck des elementaren Schwefels in der angeregten Füllung wenigstens eine Atmosphäre beträgt.

8. Vorrichtung nach Anspruch 6 oder 7, wobei der Lampenkolben keine Elektroden aufweist und wobei die Einrichtung zum Anregen die Füllung mit einer Mikrowellen- oder Hochfrequenzleistung beaufschlagt.

9. Vorrichtung nach Anspruch 8, wobei die Mikrowellen- oder Hochfrequenzleistung, mit der die Füllung beaufschlagt wird, eine Leistungsdichte von wenigstens 50 Watt/Rauminhalt aufweist.

10. Vorrichtung nach Anspruch 3 oder 7, wobei der Lampenkolben Elektroden aufweist.

11. Lampenkolben zum Liefern sichtbarer Strahlung, enthaltend
einen lichtdurchlässigen Mantel und
eine Füllung in dem Mantel, die elementares, gasförmiges Selen enthält, das beim Anregen der Füllung beim Betrieb durch eine ausreichende Leistung in einer derartigen Menge gewonnen werden kann, daß die Füllung, wenn sie durch eine ausreichende Leistung angeregt wird, infolge des elementaren Selens sichtbare Strahlung emittiert, wobei im wesentlichen die gesamte Strahlung infolge des elementaren Selens in einem zusammenhängenden Band bei Wellenlängen oberhalb von 400 nm emittiert wird.

12. Lampenkolben nach Anspruch 11, in Zusammenwirken mit
einer Einrichtung zum Anregen der Füllung mit einer ausreichenden Leistung, um zu bewirken, daß sie die sichtbare Strahlung emittiert, die fast vollständig bei Wellenlängen oberhalb von 400 nm emittiert wird.

13. Vorrichtung nach Anspruch 12, wobei die sichtbare Strahlung aus dem Kolben in erster Linie vom elementaren Selen herrührt.

14. Vorrichtung nach Anspruch 12, wobei die vom elementaren Selen emittierte Strahlung Molekularstrahlung ist.

15. Vorrichtung nach Anspruch 13, wobei der Druck der Füllung während des Betriebs wenigstens eine Atmosphäre beträgt.

16. Vorrichtung nach Anspruch 15, wobei der Partialdruck des elementaren Selens während des Betriebs wenigstens eine Atmosphäre beträgt.

17. Vorrichtung nach Anspruch 15 oder 16, wobei der Lampenkolben keine Elektroden aufweist und wobei die Einrichtung zum Anregen die Füllung mit einer Mikrowellen- oder Hochfrequenzleistung beaufschlagt.

18. Vorrichtung nach Anspruch 17, wobei die Mikrowellen- oder Hochfrequenzleistung, mit der die Füllung beaufschlagt wird, eine Leistungsdichte von wenigstens 50 Watt/Rauminhalt aufweist.

19. Vorrichtung nach Anspruch 13 oder 16, wobei der Lampenkolben Elektroden aufweist.

20. Vorrichtung nach Anspruch 13, wobei die Füllung weitherhin ein Zündgas enthält.

21. Vorrichtung nach Anspruch 10 oder 19, wobei die Elektroden Graphitteile sind.

22. Vorrichtung nach Anspruch 21, wobei die Schäfte der Graphitelektroden mit Aluminiumoxid überzogen sind.

23. Vorrichtung nach Anspruch 22, wobei sich zwischen der Graphitelektrode und dem Aluminiumoxid eine Platinschicht befindet.

24. Vorrichtung nach Anspruch 21, wobei die Schäfte der Elektroden mit Platin überzogen sind.

25. Vorrichtung nach Anspruch 10 oder 19, wobei die Elektroden aus Cermet bestehen.

26. Vorrichtung nach Anspruch 10 oder 19, wobei die Elektroden aus Platin, Rhenium oder Osmium bestehen.

27. Vorrichtung nach Anspruch 10 oder 19, wobei die Elektroden mit einer Elektronen aussendenden Substanz beschichtet sind.

28. Vorrichtung nach Anspruch 3 oder 13, wobei die angeregte Füllung Quecksilber enthält.

29. Vorrichtung nach Anspruch 3 oder 13, wobei die angeregte Füllung Natrium enthält.

30. Vorrichtung nach Anspruch 3 oder 13, wobei die angeregte Füllung Arsen oder Wismut enthält.

## Revendications

1. Ampoule de lampe destinée à fournir un rayonnement visible en fonctionnement, comprenant
une enveloppe transmettant la lumière et
un remplissage de ladite enveloppe comportant du soufre élémentaire sous forme gazeuse, pouvant être obtenu lorsque ledit remplissage est excité en fonctionnement par une énergie suffisante, dans une quantité telle que le remplissage excité émet un rayonnement visible provenant du soufre élémentaire, sensiblement la totalité du rayonnement provenant du soufre élémentaire étant émise dans une bande continue, à des longueurs d'onde supérieures à 350 nm.

2. Ampoule de lampe suivant la revendication 1, combinée à un moyen servant à exciter ledit remplissage avec une énergie suffisante pour obtenir en fonctionnement ledit soufre élémentaire sous forme gazeuse qui émet ledit rayonnement visible, sensiblement la totalité dudit rayonnement étant émise dans une bande continue, à des longueurs d'onde supérieures à 350 nm.

3. Appareil suivant la revendication 2, dans lequel ledit rayonnement visible émis par l'ampoule provient principalement dudit soufre élémentaire.

4. Appareil suivant la revendication 3, dans lequel ledit remplissage comporte en outre un gaz de démarrage.

5. Appareil suivant la revendication 3, dans lequel le rayonnement visible est un rayonnement moléculaire émis par le soufre.

6. Appareil suivant la revendication 3, dans lequel la pression du remplissage excité est d'au moins une atmosphère.

7. Appareil suivant la revendication 6, dans lequel la pression partielle du soufre élémentaire du remplissage excité est d'au moins une atmosphère.

8. Appareil suivant la revendication 6 ou 7, dans lequel ladite ampoule de lampe ne comporte pas d'électrode, et ledit moyen d'excitation applique une énergie d'hyperfréquence ou de radiofréquence au remplissage.

9. Appareil suivant la revendication 8, dans lequel l'énergie hyperfréquence ou radiofréquence qui est appliquée au remplissage est à une puissance volumique d'au moins 50 watts/cm³.

10. Appareil suivant la revendication 3 ou 7, dans lequel ladite ampoule de lampe comporte des électrodes.

11. Ampoule de lampe destinée à fournir un rayonnement visible, comprenant
une enveloppe transmettant la lumière et
un remplissage de l'enveloppe, comprenant du sélénium élémentaire sous forme gazeuse, pouvant être obtenu lorsque ledit remplissage est excité en fonctionnement par une énergie suffisante, dans une quantité telle pendant l'excitation que lorsque le remplissage est excité avec une énergie suffisante, le remplissage excité émet un rayonnement visible à partir du sélénium élémentaire, sensiblement la totalité du rayonnement provenant du sélénium élémentaire étant émise dans une bande continue, à des longueurs d'onde supérieures à 400 nm.

12. Ampoule de lampe suivant la revendication 11, combinée à :
un moyen servant à exciter ledit remplissage avec une énergie suffisante pour lui faire émettre ledit rayonnement visible, sensiblement la totalité dudit rayonnement étant émise à des longueurs d'onde supérieures à 400 nm.

13. Appareil suivant la revendication 12, dans lequel ledit rayonnement visible émis par l'ampoule provient principalement dudit sélénium élémentaire.

14. Appareil suivant la revendication 12, dans lequel le rayonnement visible est un rayonnement moléculaire émis par le sélénium élémentaire.

15. Appareil suivant la revendication 13, dans lequel la pression du remplissage pendant le fonctionnement est d'au moins une atmosphère.

16. Appareil suivant la revendication 15, dans lequel la pression partielle du sélénium élémentaire pendant le fonctionnement est d'au moins une atmosphère.

17. Appareil suivant la revendication 15 ou 16, dans lequel ladite ampoule de lampe ne comporte pas d'électrode, et ledit moyen d'excitation applique une énergie hyperfréquence ou radiofréquence au remplissage.

18. Appareil suivant la revendication 17, dans lequel ladite énergie hyperfréquence ou radiofréquence qui est appliquée au remplissage est à une puissance volumique d'au moins 50 watts/cm³.

19. Appareil suivant la revendication 13 ou 16, dans lequel ladite ampoule de lampe comporte des électrodes.

20. Appareil suivant la revendication 13, dans lequel ledit remplissage comporte en outre un gaz de démarrage.

21. Appareil suivant la revendication 10 ou 19, dans lequel les électrodes sont des éléments de graphite.

22. Appareil suivant la revendication 21, dans lequel les tiges des électrodes en graphite sont recouvertes d'oxyde d'aluminium.

23. Appareil suivant la revendication 22, dans lequel une couche de platine est placée entre l'électrode en graphite et l'oxyde d'aluminium.

24. Appareil suivant la revendication 21, dans lequel les tiges des électrodes sont recouvertes de platine.

25. Appareil suivant la revendication 10 ou 19, dans lequel les électrodes sont constituées de cermet.

26. Appareil suivant la revendication 10 ou 19, dans lequel les électrodes sont constituées de platine, de rhénium ou d'osmium.

27. Appareil suivant la revendication 10 ou 19, dans lequel les électrodes sont revêtues d'une substance à émission électronique.

28. Appareil suivant la revendication 3 ou 13, dans lequel le remplissage excité comporte du mercure.

29. Appareil suivant la revendication 3 ou 13, dans lequel le remplissage excité comporte du sodium.

30. Appareil suivant la revendication 3 ou 13, dans lequel le remplissage excité comporte de l'arsenic ou du bismuth.
